# FASCICULE DE BREVET EUROPEEN

(11) **EP 2 770 809 B1**
(45) Date de publication et mention de la délivrance du brevet: **10.04.2019**
(21) Numéro de dépôt: 14153964.3
(22) Date de dépôt: 05.02.2014
(51) Int. Cl.: H05K 7/20

(54) **Carte électronique**
Elektronische Karte
Electronic card

(30) Priorité: 20.02.2013 FR 1351436
(43) Date de publication de la demande: 27.08.2014
(73) Titulaire: BULL SAS, 78340 Les Clayes sous Bois (FR)
(72) Inventeur: Demange, Fabien, 78300 POISSY (FR)
(74) Mandataire: Camus, Olivier Jean-Claude

(56) Documents cités:
- US-A- 6 016 251
- US-A1- 2002 070 444
- US-A1- 2002 167 799
- US-A1- 2009 056 925

## Description

### DOMAINE TECHNIQUE

La présente invention concerne une carte électronique avec un dissipateur thermique pour processeur.

### ETAT DE LA TECHNIQUE ANTERIEUR

Les processeurs de calcul dégagent de la chaleur et doivent donc être refroidis. Pour cela, on utilise généralement des radiateurs qui sont fixés sur les processeurs. Les radiateurs sont pourvus d'ailettes au travers desquelles est ventilé de l'air de refroidissement permettant de refroidir les processeurs. Toutefois, ces radiateurs sont relativement encombrants. En outre, ils ne peuvent être utilisés que dans les dispositifs dans lesquels la circulation d'air est importante (ventilation forcée).

Dans ce domaine, on connait dans l'état de la technique le document US 2002/167799A1.

### EXPOSE DE L'INVENTION

L'invention vise à remédier aux inconvénients de l'état de la technique en proposant un système de refroidissement présentant une efficacité de refroidissement améliorée, y compris dans les cas où il y a peu voir pas de circulation d'air.

Un autre objet de l'invention est de proposer un système de refroidissement d'un processeur fixé sur un support qui permette une maintenance aisée du processeur et qui permette notamment un démontage aisé du processeur, par exemple en cas de panne.

L'invention vise également à proposer un système de refroidissement d'un processeur qui présente un encombrement réduit.

Pour ce faire, est proposé selon un premier aspect de l'invention, une carte électronique comportant :
- Un support;
- Un processeur;
- Une source froide;
- Un dissipateur thermique, comportant :
   - une zone d'échange thermique principale apte à venir en appui contre un processeur;
   - au moins une zone d'échange thermique périphérique apte à être en contact thermique une source froide,
   - au moins un caloduc reliant la zone d'échange thermique principale à la zone d'échange thermique périphérique, le caloduc contenant un fluide caloporteur ;
   le processeur étant situé entre le dissipateur thermique et le support, la zone d'échange thermique principale étant en appui sur le processeur, caractérisé en ce que la zone d'échange thermique périphérique est reliée thermiquement à la source froide, la source froide étant une plaque froide s'étendant parallèlement au support, la carte électronique comportant en outre d'autres composants électroniques que le processeur, ces composants électroniques étant fixés sur le support, la plaque froide recouvrant tous les composants électroniques fixés sur le support qui présentent une hauteur inférieure à la somme de:
   - la distance entre la plaque froide et le support; et de
   l'épaisseur de la plaque froide.

Plus précisément, le caloduc est de préférence apte à assurer le transfert thermique par transition de phase liquide / gazeuse du fluide caloporteur hermétiquement emprisonné.

Cette carte électronique équipée d'un tel dissipateur thermique est très avantageuse car le dissipateur est très compact. En outre, il permet d'évacuer la chaleur générée par le processeur via la zone d'échange thermique principale qui recueille la chaleur générée par le processeur. La chaleur recueillie par la zone d'échange principale est ensuite dirigée vers la zone d'échange thermique périphérique et donc vers la source froide via le caloduc.

Dans ce document, « venir en appui » signifie « appuyer ». Le fait qu'une première partie soit ou vienne en appui contre une deuxième partie signifie qu'elle appuie contre cette deuxième partie. Pour cela, la première partie peut être en contact avec la deuxième partie, ou alors il peut y avoir un élément entre eux, et notamment une interface thermique.

La carte électronique selon l'invention peut également comprendre une ou plusieurs des caractéristiques techniques ci-après prises individuellement ou selon toutes les combinaisons techniquement possibles.

La zone d'échange thermique principale comporte de préférence une surface d'appui apte à venir en appui contre le processeur. Cette surface d'appui est de préférence plane de façon à améliorer le contact thermique entre le dissipateur thermique et le processeur.

Selon différents modes de réalisation, le dissipateur thermique de la carte électronique peut comporter une zone d'échange thermique périphérique continue qui s'étend autour de la zone d'échange thermique principale ou alors il peut comporter plusieurs zones d'échange thermique périphériques disposées autour de la zone d'échange thermique principale. Selon un mode de réalisation préférentiel, le dissipateur thermique comporte deux zones d'échange thermique périphériques disposées de part et d'autre de la zone d'échange thermique principale.

Avantageusement, chaque zone d'échange thermique périphérique comporte une surface d'appui apte à venir en appui sur une source froide. Cette surface d'appui est de préférence plane. Ces surfaces d'appui permettent d'améliorer l'évacuation de la chaleur vers la source froide.

La carte électronique comporte de préférence des moyens de fixation principaux aptes à fixer le dissipateur thermique sur un support et à contrôler l'effort exercé par la zone d'échange thermique principale sur un processeur inséré entre cette zone d'échange thermique principale et le support. Ainsi, le dissipateur thermique permet non seulement de refroidir le processeur, mais il permet en outre de plaquer le processeur contre le support et notamment contre une interface de connexion (ou socket en anglais) située sur le support de façon à garantir la connexion du processeur à son interface de connexion.

Selon un premier mode de réalisation, chaque zone d'échange thermique périphérique est immobile par rapport à la zone d'échange thermique principale. Dans ce cas, chaque zone d'échange thermique périphérique et la zone d'échange thermique principale sont de préférence solidaires d'un même corps principal indéformable. Le caloduc s'étend alors entièrement à l'intérieur de ce même corps principal, de sorte que le caloduc ne peut pas se déformer. Ce mode de réalisation présente l'avantage d'avoir un dissipateur thermique simple à réaliser et solide.

Selon un deuxième mode de réalisation, chaque zone d'échange thermique périphérique est mobile par rapport à la zone d'échange thermique principale, le caloduc étant flexible. Dans ce cas, chaque zone d'échange thermique périphérique appartient de préférence à un corps périphérique distinct du corps principal auquel appartient la zone d'échange thermique principale. Ledit corps périphérique est relié au corps principal par le caloduc qui est flexible. Ce mode de réalisation permet d'améliorer l'évacuation de la chaleur car les contacts thermiques entre le dissipateur thermique et la source froide d'une part et le processeur d'autre part sont améliorés.

Avantageusement, la carte électronique équipée du dissipateur thermique comporte des moyens de fixation secondaires aptes à fixer chaque zone d'échange thermique périphérique sur une source froide. Ainsi, chaque zone d'échange thermique périphérique peut être fixée indépendamment de la zone d'échange thermique principale, ce qui permet d'améliorer le contact thermique d'une part entre le processeur et la zone d'échange thermique principale et d'autre part entre chaque zone d'échange thermique périphérique et la source froide. Toutefois, même si ce mode de réalisation permet des échanges thermiques améliorés, il est plus compliqué à réaliser et plus fragile.

La carte électronique ainsi formée est particulièrement avantageuse car le processeur est facilement accessible malgré la présence de son système de refroidissement formé par le dissipateur thermique. En effet, au-dessus du processeur on ne trouve que le dissipateur thermique, qui peut être facilement enlevé pour permettre l'accès au processeur.

Avantageusement, la zone d'échange thermique principale est reliée thermiquement au processeur par l'intermédiaire d'un matériau d'interface thermique. Ce matériau d'interface thermique est de préférence une graisse thermique. Ce matériau d'interface thermique permet de garantir le contact thermique entre le dissipateur thermique et le processeur malgré la présence d'imperfections à la surface de la zone d'échange thermique principale.

Avantageusement, chaque zone d'échange thermique périphérique est reliée thermiquement à la source froide par l'intermédiaire d'un matériau d'interface thermique. Ce matériau d'interface thermique est de préférence une graisse thermique. Ce matériau d'interface thermique permet de garantir le contact thermique entre la source froide et chaque zone d'échange thermique périphérique malgré la présence d'imperfections à la surface de la zone d'échange thermique périphérique.

Selon un mode de réalisation préférentiel, le dissipateur thermique de la carte électronique est fixé sur le support par des moyens de fixation principaux de façon à ce que la zone d'échange thermique principale soit en appui contre le processeur en exerçant sur le processeur un effort prédéterminé. L'effort prédéterminé est de préférence choisi de façon à :
- garantir un contact thermique entre la zone d'échange thermique principale et le processeur malgré d'éventuelles dilations thermiques des composants, et à
- garantir un contact électrique entre le processeur et son interface de connexion disposée entre le support et le processeur.

La source froide comporte de préférence une plaque froide. La plaque froide comporte de préférence au moins un canal apte à être parcouru par un fluide caloporteur.

La plaque froide s'étend de préférence parallèlement au support.

La plaque froide présente de préférence des dimensions extérieures sensiblement égales à celle du support.

La carte électronique comporte de préférence d'autres composants électroniques que le processeur, ces composants électroniques étant fixés sur le support. La plaque froide recouvre de préférence tous les composants électroniques fixés sur le support qui présentent une hauteur inférieure à la somme de :
- la distance entre la plaque froide et le support ; et de
- l'épaisseur de la plaque froide.

La plaque froide permet donc de refroidir tous les composants électroniques qu'elle recouvre, ainsi que le support.

La plaque froide comporte de préférence une ouverture traversante, le processeur traversant l'ouverture traversante. Ainsi, le processeur est accessible malgré la présence de la plaque froide. En outre, il est refroidi par le dissipateur thermique et reste facilement accessible.

Chaque zone d'échange thermique périphérique est de préférence maintenue en appui sur la plaque froide.

### BREVE DESCRIPTION DES FIGURES

D'autres caractéristiques et avantages de l'invention ressortiront à la lecture de la description détaillée qui suit, en référence aux figures annexées, qui illustrent :
- La figure 1, une vue en perspective d'un dissipateur thermique utilisé dans un mode de réalisation de l'invention ;
- La figure 2, une vue de dessus du dissipateur thermique de la figure 1 ;
- La figure 3, une vue en coupe du dissipateur thermique de la figure 1 lorsqu'il est intégré à une carte électronique ;
- La figure 4, une vue agrandie des moyens de fixation principaux du dissipateur thermique de la figure 1 ;
- La figure 5, une vue de dessus d'une carte électronique sur laquelle est fixée le dissipateur thermique de la figure 1 ;
- Les figures 6 et 7, des vues en perspective permettant d'illustrer les étapes d'un procédé de fabrication du dissipateur thermique de la figure 1 ;
- La figure 8, une vue en perspective d'un dissipateur thermique selon un autre mode de réalisation de l'invention ;
- La figure 9, une vue de dessus du dissipateur thermique de la figure 8 ;
- La figure 10, une vue de côté du dissipateur thermique de la figure 8 ;

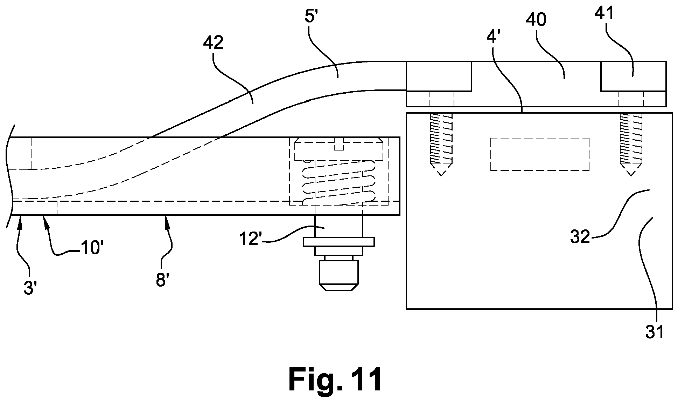

- La figure 11, une vue agrandie d'une partie du dissipateur thermique de la figure 8, fixé sur une source froide.

Les éléments identiques ou similaires sont repérés par des signes de références identiques sur l'ensemble des figures.

### DESCRIPTION DETAILLEE D'AU MOINS UN MODE DE REALISATION

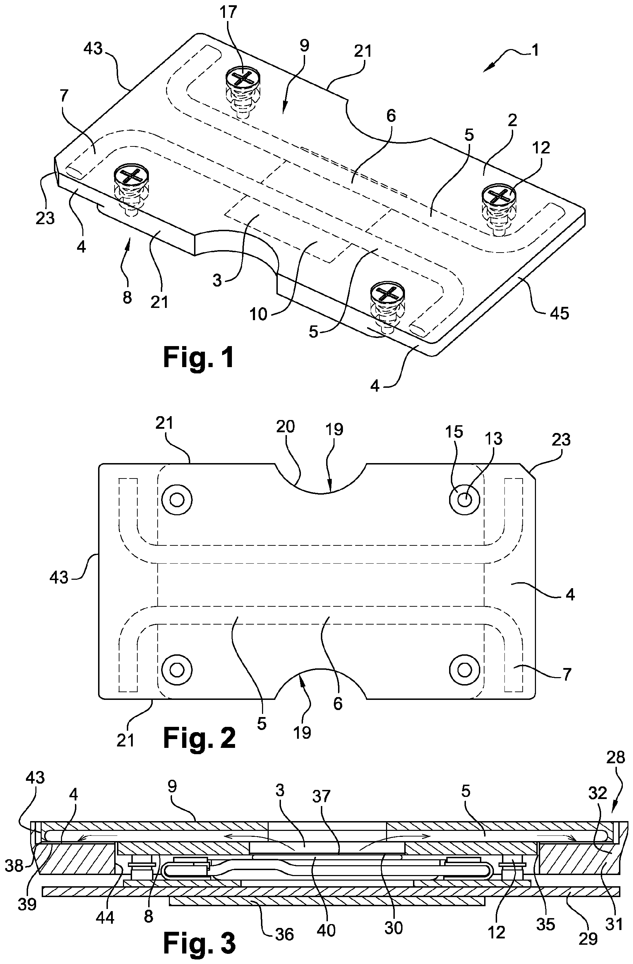

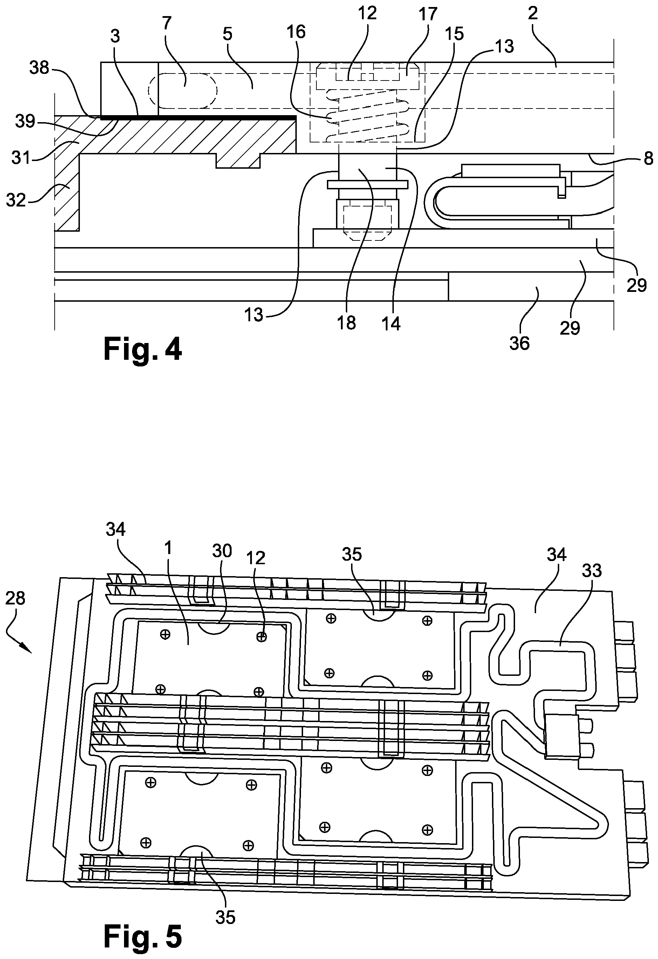

Les figures 1 à 7 représentent un dissipateur thermique 1 utilisé dans un mode de réalisation de l'invention.

Le dissipateur thermique 1 comporte une zone d'échange thermique principale 3 apte à venir en appui contre un processeur à refroidir. Le dissipateur thermique 1 comporte également deux zones d'échange thermique périphériques 4 aptes à venir en contact thermique avec une source froide.

La zone d'échange thermique principale 3 est reliée aux zones d'échange thermique périphériques 4 par au moins un caloduc 5, et plus précisément dans ce mode de réalisation par deux caloducs 5. Chaque caloduc 5 est de préférence formé par un tube, de préférence en cuivre, de façon à optimiser le transfert de chaleur. La zone d'échange thermique principale 3 se trouve de préférence au niveau du centre 6 de chaque caloduc 5, tandis que les zones d'échange thermique périphériques se trouvent au niveau des extrémités 7 de chaque caloduc. Chaque caloduc 5 contient de préférence un fluide caloporteur. Ce fluide caloporteur est de préférence à l'état liquide à température ambiante et il se transforme en gaz lorsque le processeur dégage de la chaleur de façon à améliorer le transport de la chaleur à travers le caloduc.

Dans ce mode de réalisation, le dissipateur thermique 1 comporte un corps principal 2 formé par une plaque métallique. La plaque métallique est réalisée dans un matériau conducteur thermiquement. Ce matériau peut par exemple être de l'aluminium, mais on pourrait aussi envisager de réaliser la plaque métallique en cuivre. Le corps principal 2 comporte une surface inférieure 8 destinée à faire face au processeur à refroidir, et une surface supérieure 9, qui est la surface du corps principal qui s'étend parallèlement à la surface inférieure 8.

Dans ce mode de réalisation, la zone d'échange thermique principale 3 est formée :
- Soit directement par une partie de la surface inférieure 8 du corps principal 2 et par la partie de chaque caloduc 5 qui s'étendent à travers cette partie; ce cas est avantageux car ainsi les caloducs sont au plus près du processeur à refroidir ce qui permet d'optimiser son refroidissement ;
- Soit, comme représenté sur la figure 1, par une plaque additionnelle 10 fixée sur la surface inférieure 8 du corps principal 2. Cette plaque additionnelle 10 est réalisée dans un matériau conducteur thermiquement, par exemple en cuivre. Cette plaque additionnelle 10 présente une épaisseur réduite, par exemple de l'ordre de 1mm, afin d'optimiser les échanges thermiques. Dans ce cas, la zone d'échange thermique principale 3 est de préférence formée par une surface d'appui plane, de façon à améliorer le contact thermique entre le dissipateur thermique et le processeur à refroidir.

La zone d'échange thermique principale 3 est de préférence située sensiblement au centre du corps principal 2.

Les zones d'échange thermique périphériques 4 sont de préférence situées de part et d'autre de la zone d'échange thermique principale 3.

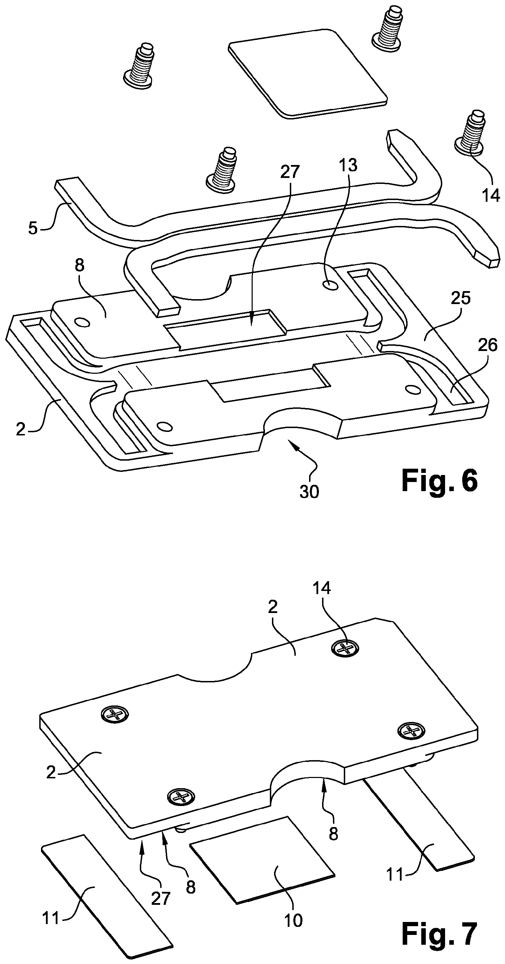

Dans ce mode de réalisation, chaque zone d'échange thermique périphérique 4 est formée :
- Soit directement par une partie de la surface inférieure 8 du corps principal 2 et par la partie de chaque caloduc 5 qui s'y trouve, ce qui permet, comme expliqué précédemment, d'optimiser les échanges thermiques en ayant les caloducs au plus près de la source froide ;
- Soit, comme représenté sur la figure 7, par une plaque additionnelle 11 fixée sur la surface inférieure 8 du corps principal 2. Cette plaque additionnelle 11 est réalisée dans un matériau conducteur thermiquement, par exemple en cuivre. Cette plaque additionnelle 11 présente une épaisseur réduite, par exemple de l'ordre de 1mm, afin d'optimiser les échanges thermiques. Dans ce cas, la plaque additionnelle 11 est de préférence plane de façon à améliorer le contact thermique entre les zones d'échange thermique périphériques et la source froide.

Les extrémités 7 des caloducs 5 s'étendent de préférence au-dessus de chaque zone d'échange thermique périphérique 4 de façon à augmenter le transfert thermique entre les caloducs 5 et les zones d'échange thermiques périphérique 4.

Le dissipateur thermique 1 comporte également des moyens de fixation principaux 12 permettant de fixer le dissipateur thermique à un support.

Les moyens de fixation principaux 12 sont également aptes à contrôler l'effort exercé par la zone d'échange thermique principale sur un processeur inséré entre cette zone et le support. Cet effort est de préférence compris entre 250 et 350 N.

Pour cela, les moyens de fixation principaux 12 comportent de préférence au moins:
- Un orifice 13 traversant réalisé dans le corps principal 2, l'orifice étant entouré par un rebord 15 ;
- Une vis 14 insérée dans l'orifice 13, la vis comportant une tête de vis 17 et un corps de vis 18 ;
- Un ressort 16 comprimé entre la tête de vis 17 et le rebord 15. La compression du ressort 16 permet de choisir l'effort exercé par la zone d'échange thermique principale sur un processeur inséré entre cette zone et le support.

Par ailleurs, le dissipateur thermique 1 comporte de préférence des moyens de préhension 19 permettant de faciliter la préhension du dissipateur thermique. Ces moyens de préhension 19 sont de préférence formés par une découpe 20 réalisée de chaque côté latéral 21 du corps principal 2. Chaque découpe 20 présente de préférence des dimensions permettant à un utilisateur moyen d'insérer un doigt dans la découpe 20.

On peut envisager d'avoir un corps principal 2 qui présente une section rectangulaire de façon à optimiser sa fabrication, mais on peut également envisager d'avoir un corps principal 2 qui présente une section trapézoïdale de façon à optimiser l'espace disponible pour le dissipateur thermique. Dans le cas où un des côtés latéral 21 du corps principal 2 est plus long que l'autre, ou plus généralement dans les cas où le dissipateur thermique n'est pas totalement symétrique, le dissipateur thermique comporte de préférence au moins des moyens d'orientation permettant d'indiquer à un opérateur dans quel sens placer le dissipateur thermique sur une carte électronique. Cette marque est de préférence formée par un coin 23 du corps principal 2 qui est biseauté, au contraire des autres coins qui ne le sont pas. Plus généralement, on peut envisager de réaliser n'importe quelle marque sur un des coins du corps principal 2, tandis que les autres coins du corps principal ne présentent pas cette marque, ou inversement.

En référence aux figures 6 et 7, un procédé de fabrication d'un dissipateur thermique 1 utilisé dans une carte électronique selon l'invention va maintenant être décrit. Le corps principal 2 est tout d'abord réalisé à partir d'une plaque métallique 25. Les caloducs 5 sont ensuite fixés au corps principal 2. Pour cela, les caloducs peuvent par exemple être assemblés au corps principal 2 par une méthode de coulée sous pression (die casting en anglais). On peut également envisager d'usiner des rainures 26 dans la plaque métallique 25, les caloducs 5 étant ensuite insérés dans ces rainures 26. En outre, les caloducs 5 sont de préférence solidarisés au corps principal 2 par une colle ou un autre matériau d'assemblage. Les caloducs 5 sont de préférence insérés du côté de la surface inférieure 8 du corps principal 2 de façon à ce que les caloducs 5 soient au plus près du processeur à refroidir et de la source froide, et donc que les échanges thermiques soient optimisés.

Comme expliqué précédemment, les zones d'échange thermique 3, 4 peuvent être formées directement par des parties de la surface inférieure 8 du corps principal 2, ou alors elles peuvent être formées par des plaques additionnelles 10, 11 rapportées contre la surface inférieure 8 du corps principal 2.

Dans ce cas, la surface inférieure 8 est de préférence usinée de façon à avoir des emplacements d'accueil 27 là où seront placées les plaques additionnelles 10, 11, ce qui permet à la fois d'avoir un dissipateur thermique plus solide, et de choisir la distance entre la surface supérieure 9 du corps principal 2 et chaque zone d'échange thermique. Les plaques additionnelles 10, 11 sont donc placées dans leur emplacement d'accueil 27 et de préférence solidarisées dans ces emplacements d'accueil 27, par exemple par collage.

Une carte électronique 28 comportant un dissipateur thermique selon l'invention va maintenant être décrite plus en détail en référence aux figures 3 à 5.

La carte électronique 28 comporte un support 29. Ce support 29 est formé par un ou plusieurs circuits imprimés de type PCB (printed circuit boad) disposés les uns à côté des autres. La carte électronique 28 comporte également des composants électroniques fixés sur le support 29. Parmi ces composants électroniques, la carte électronique comporte notamment au moins un processeur 30. Dans le cas présent, la carte électronique 28 comporte quatre processeurs 30 et des barrettes mémoires 34. Par ailleurs, la carte électronique 28 comporte une source froide 32 permettant de refroidir la carte électronique. Cette source froide 32 comporte une plaque froide 31. La plaque froide 31 est une plaque 34 réalisée dans un matériau conducteur thermiquement qui comporte des canaux 33 dans lesquels circule un fluide caloporteur. La plaque froide 31 présente des dimensions extérieures sensiblement égales à celles du support 28, de sorte qu'elle recouvre tout le support 28 et les composants électroniques qui sont fixés sur le support, à l'exception :
- Des composants électroniques qui présentent une hauteur supérieure à la somme de la distance entre le support et la plaque froide et de l'épaisseur de la plaque froide. Dans le cas présent, c'est le cas des processeurs 30 et des barrettes mémoires 34 ;
- Des composants auxquels on veut avoir accès, par exemple pour la maintenance ou en cas de panne : dans le cas présent c'est le cas des processeurs 30.

Ces composants électroniques, qui ne sont pas recouverts par la plaque froide 31, sont appelés composants accessibles dans la suite.

La plaque froide 31 comporte donc des ouvertures traversantes 35 réalisées au niveau des composants accessibles 30, 34 afin de permettre l'accès aux composants accessibles malgré la présence de la plaque froide 31. On peut ainsi avoir accès aux composants accessibles 30, 34 sans avoir à retirer la plaque froide 31, qui peut donc rester fixée sur le support. La plaque froide 31 permet donc un refroidissement efficace de toute la carte électronique à l'exception des composants accessibles 30, 34.

Pour refroidir les composants accessibles, on utilise donc des dissipateurs thermiques additionnels, et notamment dans le cas des processeurs 30, on utilise des dissipateurs thermiques selon l'invention. Dans le cas des figures 3 à 5, les dissipateurs thermiques utilisés pour refroidir les processeurs sont des dissipateurs thermiques tels que décrit précédemment.

Ainsi, en référence à la figure 3, le dissipateur thermique 1 utilisé pour refroidir un processeur 30 est fixé sur le support 29 de façon à ce que :
- La zone d'échange thermique principale 3 soit en appui contre le processeur 30 ;
- Les zones d'échange thermique périphérique 4 soient en appui sur la plaque froide 31.

Le dissipateur thermique 1 doit en outre exercer un effort compris entre 250 et 350 N, de préférence 275 N, sur le processeur de façon à le plaquer contre le support 28 avec cette force. On garantit ainsi le contact entre le processeur 30 et son interface de connexion 36 qui est située au niveau du support 29.

Le dissipateur thermique 1 comporte de préférence des dimensions supérieures à celles de l'ouverture traversante 35 dans laquelle est inséré le processeur 30 que le dissipateur thermique 1 refroidit. Plus précisément, le dissipateur thermique 1 présente de préférence des dimensions telles que les zones d'échange thermique périphériques 4 viennent en appui sur la plaque froide 31 lorsque le processeur 30 est inséré dans l'ouverture traversante 35 et que la zone d'échange thermique principale 3 est en appui sur le processeur 30.

Une interface thermique 37 est de préférence insérée entre la zone d'échange thermique principale 3 et le processeur 30 de façon à garantir le contact entre la zone d'échange thermique principale 3 et le processeur 30. Pour les mêmes raisons, une interface thermique 38 est de préférence insérée entre chaque zone d'échange thermique périphérique 4 et la plaque froide 31.

Chaque interface thermique 37, 38 présente de préférence une épaisseur comprise entre 0.1 et0.5 mm. L'épaisseur de l'interface thermique doit être suffisante pour garantir le contact entre les zones d'échanges thermique 3, 4 et le processeur 30 et/ou la plaque froide 31, tout en étant la plus mince possible de façon à optimiser les échanges thermiques. Le matériau choisi pour réaliser l'interface thermique est de préférence une graisse thermique, mais on pourrait également utiliser des coussinets d'interface thermique de type « gap pad » en fonction des performances thermiques à atteindre.

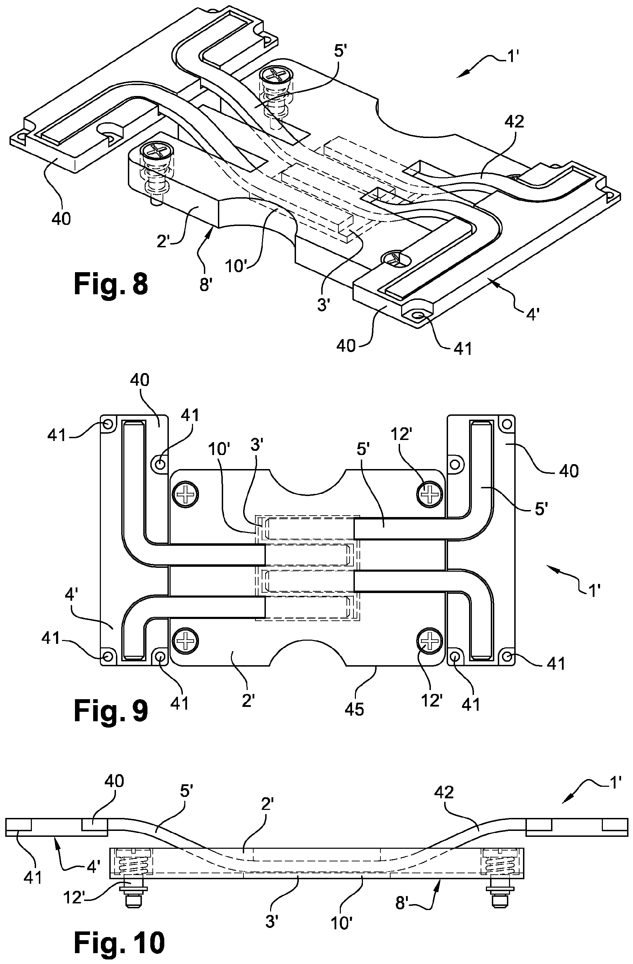

Les figures 8 à 10 représentent un dissipateur thermique 1' selon un autre mode de réalisation de l'invention. Ce dissipateur thermique 1' pourrait également être utilisé pour refroidir les processeurs 30 de la carte électronique décrite précédemment.

Ce dissipateur thermique 1' est semblable à celui décrit précédemment, à l'exception du fait que les caloducs 5' du dissipateur thermique 1' qui relient la zone d'échange thermique principale 3' à chaque zone d'échange thermique périphérique 4' sont flexibles de sorte que chaque zone d'échange thermique périphérique 4' peut être fixée sur une source froide à une hauteur variable par rapport à la hauteur à laquelle est fixée la zone d'échange thermique principale 3'.

Le corps principal 2, 2' du dissipateur thermique s'étend suivant un plan de référence 45. Dans ce document, on appelle « hauteur » une dimension suivant un axe perpendiculaire à ce plan de référence 45.

En effet, dans le mode de réalisation décrit précédemment, les zones d'échange thermiques périphériques 4 sont fixées sur le corps principal 2 du dissipateur thermique 1, tout comme la zone d'échange thermique principale 3 et les caloducs 5 sont intégrés à ce corps principal 2 de sorte que les zones d'échange thermique périphériques 4 sont immobiles par rapport à la zone d'échange thermique principale 3. Ainsi, dans le mode de réalisation précédent, seules les interfaces thermiques 38, 39 permettent de compenser les variations de hauteur entre la surface supérieure 39 de la source froide 32 et la surface supérieure 40 du processeur 30. Toutefois, les interfaces thermiques ne peuvent compenser que des faibles variations de hauteur. En outre, le dissipateur thermique 1 ne peut pas s'adapter à toutes les cartes électroniques : il est adapté uniquement aux cartes électroniques dans lesquelles la différence de hauteur entre la surface supérieure 39 de la plaque froide 31 et la surface supérieure 40 du processeur est sensiblement égale à la différence de hauteur entre chaque zone d'échange thermique périphérique et la zone d'échange thermique principale.

Le dissipateur thermique 1' qui va être décrit en référence aux figures 8 à 10 permet de remédier à ces inconvénients. Pour cela, chaque zone d'échange thermique périphérique 4' est mobile par rapport à la zone d'échange thermique principale 3'. Ainsi, chaque zone d'échange thermique périphérique 4' peut être fixée sur la source froide indépendamment de la fixation de la zone d'échange thermique principale 3' sur le processeur, ce qui permet de garantir un bon contact thermique entre le dissipateur thermique et à la fois la source froide et le processeur, et ce, quelles que soient les dilatations thermiques de ces différents éléments.

Dans ce mode de réalisation, chaque zone d'échange thermique périphérique 4' est donc mobile en hauteur par rapport à la zone d'échange thermique principale 3'.

Pour cela, le dissipateur thermique 1' comporte un corps principal 2'. Le corps principal 2' présente une surface inférieure 8' sur laquelle se trouve la zone d'échange thermique principal 3'. Comme précédemment, la zone d'échange thermique principale 3' peut être soit formée directement par une partie de la surface inférieure 8' et la partie des caloducs qui la traverse, soit par une plaque additionnelle 10' rapportée et fixée sur la surface inférieure 8'.

Chaque zone d'échange thermique périphérique 4' est situé sur une plaque périphérique 40 qui est distincte du corps principal 2'. Chaque zone d'échange thermique périphérique 4' est reliée thermiquement à la zone d'échange thermique principale 3' par l'intermédiaire de deux caloducs 5'. Les caloducs 5' sont flexibles de sorte que chaque zone d'échange thermique périphérique 4' est mobile en hauteur par rapport à la zone d'échange thermique principale 3'. Pour cela, chaque caloduc 5' comporte une partie 42 au moins qui est libre entre le corps principal 2' et la plaque périphérique 40 à laquelle ledit caloduc 5' relie le corps principal 2'. Par ailleurs, pour diminuer le risque de rupture des caloducs 5', le dissipateur thermique 1' ne comporte plus uniquement deux caloducs, mais quatre caloducs 5'. Ainsi, les deux zones d'échange thermique périphériques 4' ne sont pas reliées à la zone d'échange thermique principale 3' par les mêmes caloducs qui traversent la zone d'échange thermique principale, mais par des caloducs différents.

Chaque plaque périphérique 40 est donc reliée au corps principal 2' uniquement par l'intermédiaire de deux caloducs 5' flexibles, de sorte que chaque plaque périphérique 40 est mobile en hauteur par rapport au corps principal 2'. En outre, chaque plaque périphérique 40 comporte des moyens de fixation secondaires 41 qui permettent de fixer chaque plaque périphérique 40 sur une source froide 32 indépendamment des moyens de fixation principaux 12' qui permettent de fixer le corps principal 2' sur le support 28.

Ce mode de réalisation permet en outre d'avoir des plaques périphériques 40 qui présentent des dimensions différentes du corps principal 2' en fonction de l'espace disponible et de façon à optimiser l'efficacité du dissipateur thermique.

Naturellement l'invention n'est pas limitée aux modes de réalisation décrits en référence aux figures et des variantes pourraient être envisagées sans sortir du cadre de l'invention. Ainsi, dans le mode de réalisation décrit en référence aux figures 8 à 10, les zones d'échange thermiques périphériques étaient mobiles en hauteur uniquement par rapport à la zone d'échange thermique principale 3', mais on pourrait aussi envisager d'avoir des zones d'échanges thermiques périphériques mobiles dans d'autres directions par rapport à la zone d'échange thermique principale. Par ailleurs, dans tous les modes de réalisation décrits précédemment, les zones d'échange thermique périphériques s'étendent parallèlement à la zone d'échange thermique principale. Toutefois, on pourrait aussi envisager que les zones d'échange thermique périphériques s'étendent perpendiculairement à la zone d'échange thermique principale. Dans ce cas, le dissipateur thermique présenterait des dimensions ajustées sur celles de l'ouverture traversante 35 de la plaque froide 31 de façon à ce que le dissipateur thermique vienne s'insérer dans l'ouverture traversante 35. Les zones d'échange thermique périphériques seraient alors formées par une bordure latérale 43 du dissipateur thermique qui viendrait en contact avec une bordure latérale 44 de la plaque froide 31.

## Revendications

1. Carte électronique (28) comportant :
- Un support (29);
- Un processeur (30);
- Une source froide (32);
- Un dissipateur thermique (1, 1'), comportant :
- une zone d'échange thermique principale (3, 3') apte à venir en appui contre un processeur (30);
- au moins une zone d'échange thermique périphérique (4, 4') apte à être en contact thermique une source froide (32),
- au moins un caloduc (5, 5') reliant la zone d'échange thermique principale (3, 3') à la zone d'échange thermique périphérique (4, 4'), le caloduc (5, 5') contenant un fluide caloporteur ;
le processeur (30) étant situé entre le dissipateur thermique (1, 1') et le support (29), la zone d'échange thermique principale (3, 3') étant en appui sur le processeur (30), **caractérisé en ce que** la zone d'échange thermique périphérique (4, 4') est reliée thermiquement à la source froide (32), la source froide (32) étant une plaque froide (31) s'étendant parallèlement au support (29), la carte électronique comportant en outre d'autres composants électroniques que le processeur (30), ces composants électroniques étant fixés sur le support (29), la plaque froide (31) recouvrant tous les composants électroniques fixés sur le support qui présentent une hauteur inférieure à la somme de:
- la distance entre la plaque froide (31) et le support (29); et de
- l'épaisseur de la plaque froide (31).

2. Carte électronique (28) selon la revendication précédente, dans lequel la zone d'échange thermique principale (3, 3') comporte une surface d'appui plane apte à venir en appui contre le processeur (30), la zone d'échange thermique périphérique (4, 4') comportant une surface d'appui plane apte à venir en appui contre une source froide (32).

3. Carte électronique (28) selon l'une des revendications précédentes, comportant en outre des moyens de fixation principaux (12) aptes à fixer le dissipateur thermique (1, 1') sur un support (29) et à contrôler l'effort exercé par la zone d'échange thermique principale (3, 3') sur un processeur (30) inséré entre cette zone d'échange thermique principale (3, 3') et le support (29).

4. Carte électronique (28) selon l'une des revendications précédentes, dans lequel la zone d'échange thermique périphérique (4) est immobile par rapport à la zone d'échange thermique principale (3).

5. Carte électronique (28) selon l'une des revendications 1 à 3, dans lequel la zone d'échange thermique périphérique (4') est mobile par rapport à la zone d'échange thermique principale (3'), le caloduc (5') étant flexible.

6. Carte électronique (28) selon la revendication précédente, comportant en outre des moyens de fixation secondaires (42) aptes à fixer la zone d'échange thermique périphérique (4') sur une source froide.

7. Carte électronique (28) selon l'une des revendications précédentes, dans laquelle la zone d'échange thermique principale (3, 3') est reliée thermiquement au processeur (30) par l'intermédiaire d'une interface thermique (37), la zone d'échange thermique périphérique (4, 4') étant reliée thermiquement à la source froide (32) par l'intermédiaire d'une interface thermique (38).

8. Carte électronique (28) selon l'une des revendications précédentes, dans laquelle la plaque froide (31) comporte une ouverture traversante (35), le processeur (30)
traversant l'ouverture traversante (35).

## Patentansprüche

1. Elektronische Karte (28), umfassend:
- einen Träger (29);
- einen Prozessor (30);
- eine kalte Quelle (32);
- einen Wärmeableiter (1, 1'), umfassend:
- einen Haupt-Wärmetauscherbereich (3, 3'), der geeignet ist, gegen einen Prozessor (30) zum Aufstützen zu kommen;
- wenigstens einen umlaufenden Wärmetauscherbereich (4, 4'), der geeignet ist, im thermischen Kontakt mit einer kalten Quelle (32) zu sein;
- wenigstens ein Wärmerohr (5, 5'), das den Haupt-Wärmetauscherbereich (3, 3') mit dem umlaufenden Wärmetauscherbereich (4, 4') verbindet, wobei das Wärmerohr (5, 5') ein Wärmeträgerfluid enthält;
wobei der Prozessor (30) zwischen dem Wärmeableiter (1, 1') und dem Träger (29) angeordnet ist, wobei der Haupt-Wärmetauscherbereich (3, 3') sich auf dem Prozessor (30) aufstützt, **dadurch gekennzeichnet, dass** der umlaufende Wärmetauscherbereich (4, 4') thermisch mit der kalten Quelle (32) verbunden ist, wobei die kalte Quelle (32) eine kalte Platte (31) ist, die sich parallel zum Träger (29) erstreckt, wobei die elektronische Karte darüber hinaus weitere elektronische Bauteile als nur den Prozessor (30) umfasst, wobei diese elektronischen Bauteile auf dem Träger (29) befestigt sind, wobei die kalte Platte (31) alle elektronischen Bauteile abdeckt, die auf dem Träger befestigt sind, die eine geringere Höhe aufweisen als die Summe aus:
- der Entfernung zwischen der kalten Platte (31) und dem Träger (29); und
- der Dicke der kalten Platte (31).

2. Elektronische Karte (28) gemäß dem voranstehenden Anspruch, bei dem der Haupt-Wärmetauscherbereich (3, 3') eine ebene Stützfläche umfasst, die geeignet ist, gegen den Prozessor (30) zum Aufstützen zu kommen, wobei der umlaufende Wärmetauscherbereich (4, 4') eine ebene Stützfläche umfasst, die geeignet ist, gegen eine kalte Quelle (32) zum Aufstützen zu kommen.

3. Elektronische Karte (28) gemäß einem der voranstehenden Ansprüche, umfassend darüber hinaus Hauptbefestigungsmittel (12), die geeignet sind, den Wärmeableiter (1, 1') auf einem Träger (29) zu befestigen und die von dem Haupt-Wärmetauscherbereich (3, 3') auf einen Prozessor, der zwischen diesem Haupt-Wärmetauscherbereich (3, 3') und dem Träger (29) eingefügt ist, ausgeübte Kraft zu kontrollieren.

4. Elektronische Karte (28) gemäß einem der voranstehenden Ansprüche, bei dem der umlaufende Wärmetauscherbereich (4) im Verhältnis zum Haupt-Wärmetauscherbereich (3) unbeweglich ist.

5. Elektronische Karte (28) gemäß einem der Ansprüche 1 bis 3, bei dem der umlaufende Wärmetauscherbereich (4') im Verhältnis zum Haupt-Wärmetauscherbereich (3') beweglich ist, wobei das Wärmerohr (5') flexibel ist.

6. Elektronische Karte (28) gemäß dem voranstehenden Anspruch, umfassend darüber hinaus sekundäre Befestigungsmittel (42), die geeignet sind, den umlaufenden Wärmetauscherbereich (4') auf einer kalten Quelle zu befestigen.

7. Elektronische Karte (28) gemäß einem der voranstehenden Ansprüche, bei der der Haupt-Wärmetauscherbereich (3, 3') thermisch mit dem Prozessor (30) mittels einer thermischen Schnittstelle (37) verbunden ist, wobei der umlaufende Wärmetauscherbereich (4, 4') thermisch mit der kalten Quelle (32) mittels einer thermischen Schnittstelle (38) verbunden ist.

8. Elektronische Karte (28) gemäß einem der voranstehenden Ansprüche, bei der die kalte Platte (31) eine durchgehende Öffnung (35) umfasst, wobei der Prozessor (30) die durchgehende Öffnung (35) durchquert.

## Claims

1. Electronic card (28) comprising:
- A support (29);
- A processor (30);
- A cold source (32);
- A heat sink (1, 1'), comprising:
∘ a main heat exchange zone (3,3') able to bear against a processor (30);
∘ at least one peripheral heat exchange zone (4, 4') able to be in thermal contact with a cold source (32),
∘ at least one heat pipe (5, 5') connecting the main heat exchange zone (3, 3') to the peripheral heat exchange zone (4, 4'), the heat pipe (5, 5') containing a heat transfer fluid;
the processor (30) being located between the heat sink (1, 1') and the support (29), the main heat exchange zone (3, 3') bearing on the processor (30), **characterised in that** the peripheral heat exchange zone (4, 4') is thermally connected to the cold source (32), the cold source (32) being a cold plate (31) extending in parallel to the support (29), the electronic card further comprising electronic components other than the processor (30), these electronic components being fastened onto the support (29), the cold plate (31) covering all of the electronic components fastened on the support which have a height less than the sum of:
- the distance between the cold plate (31) and the support (29); and of
- the thickness of the cold plate (31).

2. Electronic card (28) according to the preceding claim, wherein the main heat exchange zone (3, 3') comprises a planar bearing surface able to be supported by the processor (30), the peripheral heat exchange zone (4, 4') comprising a planar bearing surface able to bear against a cold source (32).

3. Electronic card (28) according to one of the preceding claims, further comprising main means of fastening (12) able to fasten the heat sink (1, 1') onto a support (29) and to control the force exerted by the main heat exchange zone (3, 3') on a processor (30) inserted between this main heat exchange zone (3, 3') and the support (29).

4. Electronic card (28) according to one of the preceding claims, wherein the peripheral heat exchange zone (4) is immobile in relation to the main heat exchange zone (3).

5. Electronic card (28) according to one of claims 1 to 3, wherein the peripheral heat exchange zone (4') is mobile in relation to the main heat exchange zone (3'), the heat pipe (5') being flexible.

6. Electronic card (28) according to the preceding claim, further comprising secondary means of fastening (42) able to fasten the peripheral heat exchange zone (4') onto a cold source.

7. Electronic card (28) according to one of the preceding claims, wherein the main heat exchange zone (3,3') is thermally connected to the processor (30) via a thermal interface (37), the peripheral heat exchange zone (4, 4') being thermally connected to the cold source (32) via a thermal interface (38).

8. Electronic card (28) according to one of the preceding claims, wherein the cold plate (31) comprises a through-opening (35), the processor (30) passing through the through-opening (35).
